# EUROPEAN PATENT SPECIFICATION

(11) **EP 0 697 724 B1**
(45) Date of publication and mention of the grant of the patent: **10.03.1999**
(21) Application number: 94305724.0
(22) Date of filing: 02.08.1994
(51) Int. Cl.: H01L 23/15, H05K 3/00

(54) **Process for the production of a base board for printed wiring boards**
Verfahren zur Produktion einer Rohplatte für gedruckte Leiterplatten
Procédé de fabrication de carte de base pour circuit imprimé

(43) Date of publication of application: 21.02.1996
(73) Proprietor: MITSUBISHI GAS CHEMICAL COMPANY, INC., Chiyoda-ku, Tokyo (JP)
(72) Inventor: Ohya, Kazuyuki, Mitsubishi Gas, Chiyoda-ku, Tokyo (JP); Sayama, Norio, Mitsubishi Gas, Chiyoda-ku, Tokyo (JP)
(74) Representative: Woods, Geoffrey Corlett

(56) References cited:
- EP-A- 0 196 865
- EP-A- 0 411 639
- EP-A- 0 566 360
- WO-A-92/18213

## Description

The present invention relates to a novel process for the production of a base board for printed wiring, which has excellent thickness accuracy, a low coefficient of thermal expansion, high heat dissipation properties and high heat resistance, and which is useful for the use with high frequency and for directly mounting a semiconductor chip.

A printed wiring board for the use with high frequency is required to have electric properties such as small thermal dependency and a low dielectric loss tangent. In addition to these requirements, since the wavelength and the thickness of the board are generally in the same range of thickness, the board functions in a way in which parts and chips of a conventional circuit function, and for this reason, the printed wiring board is also required to have high thickness accuracy. Further, a board on which a semiconductor chip is to be directly mounted is required to have a low coefficient of thermal expansion and high heat dissipation properties.

A variety of materials having low dielectric loss tangents and a variety of base boards from ceramics have been being developed in order to meet with the above requirements, and some of them have been put to practical use.

However, a base board produced by a conventional lamination method has a thickness accuracy of within ± 5 % at best. Even if the production of the board or the board itself is devised, the ultimate thickness accuracy is within ±2 %.

For producing a base board from a ceramic, it is essential to produce the base board by calcining the ceramic at a high temperature. Therefore, when a thin base board having a thickness of about 1/40" (0.635 mm) is produced, it is difficult to maintain its thickness accuracy precisely, and further, it is very difficult to produce a base board free of distortion and strain.

Ceramic can give a base board having a low coefficient of thermal expansion and high heat dissipation properties. However, ceramic is generally poor in machinability. Therefore, studies are being made of a method in which a base board having through holes is produced by calcining a green sheet having holes in predetermined positions, or of a method in which a printed wiring network is formed on a green sheet from an electrically conductive paste which can be calcined at a high temperature, and the green sheet is calcined. And, the practical use of these methods is under way. However, the defects with these methods are that the production steps are complicated and that printed wiring boards obtained by these methods are expensive.

The development of machinable ceramics has been recently under way, and most of them are inorganic continuous porous materials. Since, however, the continuous porous material easily absorbs a liquid into their pores due to its continuous porous property, it is impossible to form a printed wiring network, for example, by electroless copper plating. Further, non-oxide-based ceramics are generally liable to react with water. In particular, AlN generates ammonia when heated to 80°C or higher in the presence of water, and it is converted into β-alumina or aluminum hydroxide. As a result, when the inorganic continuous porous material imparted with machinability is used as a base board for printed wiring, it is essentially required to form a printed wiring network in a dry state and form a resist coating in a dry state.

Further, it is conceivable to employ a method in which a block of an inorganic continuous porous material is produced from a ceramic and the block is sliced in a dry method to prepare base boards. However, although being excellent in flexural strength, this inorganic continuous porous material has inferior impact resistance. When it has a decreased thickness, it is easily fractured and difficult to slice. Moreover, it is much more difficult to process such a fragile base board for forming a printed wiring.

EP-A-566 360 discloses a process for preparing a substrate for printed using in which a thick plate-like inorganic continuous porous material (I) is wrapped with a cloth or paper the wrapped material (I) is impregnated with a thermosetting resin (II) under reduced pressure, and the thermosetting resin (II) is cured to form a composite material (III) which is then sliced into substrates.

It is an object of the present invention to provide a process for the production of a novel base board for printed wiring, which has high thickness accuracy and permits the formation of a printed wiring network by most general methods such as wet electroless copper plating without impairing the excellent properties of an inorganic continuous porous material such as a low coefficient of thermal expansion, high heat dissipation properties and high machinability.

According to the present invention, there is provided a process for the production of a base board for printed wiring, which comprises impregnating a block of an inorganic continuous porous material (I) with a thermosetting resin (II) in an impregnation vessel under reduced pressure, taking the impregnated block out of the impregnation vessel, substantially removing the thermosetting resin (II) adhering to surfaces of the impregnated block before the thermosetting resin (II) forms a gel, curing the remaining thermosetting resin under heat to form a composite material (III), and slicing the composite material (III) into base boards having a thickness of 0.2 to 2 mm and a thickness allowance of ± 5 µm or less.

Typically material (I) has an average pore diameter of from 0.1 µm to 10 µm and a porosity of from 10% to 40%.

In a preferred embodiment of the present invention, material (I) has a porosity of 12 to 36 % and an average pore diameter of from 0.5 to 6 µm. Material (I) is generally formed of aluminum nitride-hexagonal boron nitride (AlN-h-BN) or β-wollastonite (β-CaSiO₃). Typically, Material (I) is preliminarily heat-treated under reduced pressure at a temperature of from 70 to 250°C for 0.5 to 72 hours. Further, the composite material (III) is typically sliced with a multiwire saw, a multiwire saw with diamond on wire, a multiblade saw, a multiblade saw with diamond on blade or an inner diameter slicing diamond saw.

The present invention will be detailed hereinafter.

Material (I) used in the present invention is generally produced by incorporating a sintering aid and mixing aids such as an organic solvent and water to an inorganic powder as required to form a homogeneous mixture, shaping the mixture into a desired plate, cube, cylinder or other block under a high pressure or ultrahigh pressure under conditions where the mixing aid, etc., can be properly removed, completely removing the mixing aid, etc., by drying or heating, and sintering the shaped body by calcining it.

Material (I) used in the present invention is a block which preferably has the form of a plate whose surface is rectangular or square, in view of the production of Material (I) which shows little variability in physical properties among lots, maintenance of impregnatability and the use thereof as a base board for printed wiring. Material (I) preferably has a thickness of from 3 to 10 cm, a length of from 5 to 30 cm and a width of from 5 to 40 cm.

The above inorganic powder can be selected from those which are usable in an electric field in terms of heat resistance, electric properties, etc. In the present invention, the above inorganic powder is selected from those which have machinability as well as the above properties.

Specifically, examples of the above inorganic powder include a mixture of an aluminum nitride powder and a hexagonal boron nitride powder (for AlN-h-BN), a mixture of an alumina powder and a hexagonal boron powder (Al₂O₃-h-BN), a mixture of a zircon oxide powder and a hexagonal boron nitride powder (ZrO₂-h-BN), a mixture of a silicon carbide powder and a hexagonal boron nitride powder (SiC-h-BN) and a mixture of a silicon nitride powder and a hexagonal boron nitride powder (Si₃N₄-h-BN). The h-BN content of these mixtures is 10 to 50 % by weight, preferably 10 to 25 % by weight. Further, the inorganic powder includes a hexagonal boron nitride powder (h-BN), β-wollastonite (β-CaSiO₃), cordierite and mica. Particularly preferred are AlN-h-BN and β-CaSiO₃.

Material (I) is generally produced by calcining the above inorganic powder in the presence of a sintering aid which is to impart Material (I) with the desired machinability. When a mixture of an aluminum nitride powder and a hexagonal boron nitride powder is used, h-BN works as a sintering aid and a pore former, while the sintering aid can be selected from oxides of rare earth elements typified by yttria and oxides of alkaline earth elements typified by calcia. When β-CaSiO₃ is used, a sintered body having improved heat resistance can be obtained by sintering it in the presence of approximately 1 to 18 % by weight of MgO as a sintering aid.

When Material (I) is formed of any one of the above AlN-h-BN, Al₂O₃-h-BN, ZrO₂-h-BN and Si₃N₄-h-BN, the h-BN component works as a pore former, and the pore diameter depends upon the particle diameter of the powder (h-BN in particular). The smaller the particle diameter of the powder is, the smaller the pore diameter is. Further, the smaller the particle diameter of the powder is, the more improved the mechanical strength and processing accuracy are. The porosity differs depending upon the kind and amount of the used sintering aid. On the other hand, when the same sintering aid is used, the porosity differs depending upon the amount of the used h-BN component. With an increase in the amount of the h-BN component, the porosity increases, while the mechanical strength, etc., decrease. When any one powder of h-BN, β-wollastonite and mica is used, the pore size is determined depending upon the particle diameter of the powder used. With a decrease in the particle diameter of the powder, the pore size decreases and the mechanical strength and processing accuracy increase.

The base board for printed wiring, produced by the process of the present invention, is a product in which Material (I) and the thermosetting resin (II) are integrated, and it is therefore greatly improved in mechanical and chemical properties. In view of this point, it cannot be necessarily said that a base board having smaller pore diameters is always excellent.

With an increase in the pore diameter, the impregnation with the thermosetting resin (II) becomes easier. With a decrease in the pore diameter, Material (I) becomes excellent in physical properties and uniformity. Further, for producing Material (I) having less variability among lots from a fine powder of a non-oxide material such as a mixture of AIN and h-BN powders, it is also required to control the material and calcining very precisely. In view of the above points, for producing Material (I), it is preferred to select the particle diameter of the inorganic powder so that Material (I) has an average pore diameter of 0.1 to 10 µm, preferably 0.5 to 6 µm, and a porosity of 10 to 40 %, preferably 10 to 35 %, more preferably 15 to 25 %.

Further, for improving the composite material (III) in physical properties on the basis of the impregnation with the thermosetting resin (II), the apparent porosity is generally 10 to 55 %, preferably 12 to 36 %, particularly preferably 15 to 25 %.

In the base board for printed wiring, produced by the process of the present invention, for example, the dielectric loss tangent and thermal conductivity are more important than the density, strength and heat resistance, and preferred is Material (I) which is produced so as to show less variability among lots concerning the above more important properties.

The thermosetting resin (II) used in the present invention is preferably selected from thermosetting resins which are cured by addition polymerization without forming any byproducts. Typically, the thermosetting resin (II) is a phenolic resin, an epoxy resin, an unsaturated polyester resin, a diallyl phthalate resin, an acrylic resin, a cyanato resin containing cyanate esters as an essential component), a maleimide resin, a maleimide-vinyl resin, or a mixture of two or more thereof. In view of the use for impregnation, preferred are thermosetting resins which are in a liquid state at room temperature or are melted by heating and which have a low viscosity. Of the above resins, preferred is a thermosetting resin containing a cyanato resin as an essential component.

An aid for improving the thermosetting resin (II) in the affinity to Material (I) may be incorporated into the thermosetting resin (II). The above aid includes a silane coupling agent and a surfactant. Further, the thermosetting resin (II) may contain a curing catalyst for promoting the curing reaction and a flame retardant for maintaining flame retardancy when the Material (I) has a high porosity.

Material (I) is preferably stored in a closed system after produced. When Material (I) absorbs water in air, the affinity and adhesion of Material (I) to the thermosetting resin (II) may be impaired, and Material (I) may have a portion which cannot be impregnated due to absorbed water. It is therefore preferred to fully dry Material (I) before the impregnation. For this purpose, the Material (I) is dried at a temperature between 70 and 250°C under a pressure of 30 mmHg or less for 0.5 to 72 hours. Specifically, Material (I) may be heated stepwise under reduced pressure within the above ranges depending upon Material (I). When Material (I) has absorbed a liquid such as water, it is very difficult to dry it under general conditions. In particular, some of the non-oxide materials may undergo a run-away reaction at a high temperature required for drying it for a short period of time. It is hence necessary to take care when such materials are handled. For example, when heated to 80°C or higher in the presence of water, AlN-h-BN generates ammonia and is converted to β-alumina or aluminum hydroxide.

The impregnation is typically carried out by a spontaneous impregnation method in which the above Material (I) and the thermosetting resin (II) whose amount has been measured beforehand are placed in a container or mold which permits decreasing of the pressure and heating as required, preferably decreasing the pressure in the system and heating the thermosetting resin (II) to melt it for the impregnation, or by a method in which Material (I) is placed in a container or mold which permits decreasing of the pressure and heating, Material (I) is dehydrated/dried under heat by decreasing the pressure in the system as required, and gradually supplying the thermosetting resin (II), which has been melted and degassed under reduced pressure, preferably from under Material (I) at a rate meeting the impregnation rate. The pressure in the impregnation system is preferably 50 mmHg or lower, preferably 10 mmHg or lower, particularly preferably 1 mmHg or lower.

The resin (II) adhering to surfaces of Material (I) is removed for preventing the composite material (III) from undergoing cracking when the composite material (III) is formed. The required degree of the removal of the above resin (II) differs depending upon the strength of Material (I), while the above degree is that almost no resin remains when visually observed. When the removal is insufficient, cracking starts from a resin-adhering portion at a temperature between 150°C and 30°C, and in some cases, the cracking reaches the interior of Material (I).

Specifically, the resin (II) adhering to Material (I) surface is typically removed as follows. The impregnated Material (I) is taken out of the impregnation container, the resin (II) adhering to Material (I) surface is lightly cleaned with a spatula, and then the impregnated Material (I) is placed on a bed, etc., where the resin can drop off, whereby the above resin (II) can be removed by dropping and gasification on the surface before the resin (II) gels. Further, Material (I) surface can be cleaned with a cloth, etc., before the resin (II) gels. Moreover, there may be employed a mechanical means such as centrifugal separation.

The conditions for the above curing are properly selected depending upon the resin (II), and the resin (II) is completely cured.

The above composite material (III) is sliced to obtain, at the same time, a plurality of base boards having a thickness of 0.2 to 2 mm and a thickness allowance (common difference) of ± 5 µm for printed wiring.

The composite material (III) can be sliced by a method using a slicing apparatus such as an outer diameter slicing diamond saw, an inner diameter slicing diamond saw, a multiwire saw, multiwire saw with diamond on wire, a multiblade saw or a multiblade saw with diamond on blade. According to the present invention, there can be obtained base boards having a thickness of 0.2 mm to 2 mm, typically 0.4 to 1.6 mm, and having high thickness accuracy. Further, a thin base board having a thickness of about 0.1 mm can be produced by carrying out a polishing process, etc.

For slicing, generally, a combination of a plurality of the composite materials (III) which are integrated, surface to surface, with an adhesive is set at a slicing apparatus and sliced. In the process of the present invention, since the composite material(s) does not have, on its surface, a resin or a cloth which may make it difficult to slice the composite material(s), the slicing can be carried out more uniformly.

When the multi-slicing is carried out with a multiwire saw, a multiblade saw, a multiwire saw with diamond on wire, a multiblade saw with diamond on blade, generally, it is preferred to slice a combination of the composite materials into a combination of base boards having a small thickness and base boards having a large thickness at the same time rather than slicing the composite materials into many base boards having small thicknesses at the same time, although the degree of multi-slicing depends on a slicing apparatus. For slicing the material formed of aluminum nitride, no slicing method has been possible but a dry method in view of safety. However, the present invention permits a wet slicing method, particularly a slicing method using a coolant or an aqueous solution containing an abrasive material.

The base board obtained according to the process of the present invention has very high thickness accuracy, and this base board can be obtained as one having a very small thickness. Therefore, a base board which has a high dielectric constant but has a low dielectric loss tangent can be suitably used as a base board having higher performance for the use with high frequency. The composite material (III) formed in the present invention is a novel composite material in which the cured resin having a three-dimensional network structure is integrated with Material (I) having a three-dimensional network structure. Therefore, the composite material (III) has about the same hardness as that of Material (I) and greatly improved flexibility (impact strength). Therefore, the base board of the present invention has drilling processability equivalent to, or higher than, that of a general glass epoxy laminate. Further, when the base board is obtained from Material (I) having a high porosity, the base board easily permits the punching process.

When Material (I) having poor water resistance or poor acid resistance such as β-wollastonite is used for producing a base board, the base board is greatly improved in water resistance or acid resistance due to the thermosetting resin (II) used for the impregnation and cured. When the base board for printed wiring is produced from the Material (I) of AlN-h-BN, etc., the base board is structured so that AlN-h-BN having inferior water resistance is surrounded by the three-dimensional network of the resin used for the impregnation. Therefore, the base board is greatly improved in water resistance and chemical resistance, and it can be sliced using water as a medium. When the base board for printed wiring is produced from Material (I) of Al₂O₃-h-BN or ZrO₂-h-BN, generally, Al₂O₃ and ZrO₂ as a main component are too stable to carry out etching. In the present invention, however, the base board permits etching due to the presence of a portion impregnated with the thermosetting resin (II).

Therefore, either the resin side or the inorganic material side, or both are etched with an acidic, alkaline or oxidizing etching solution having room temperature or an elevated temperature as required, and the base board is surface-treated with a coupling agent, etc., whereby a conventional electroless plating method can be applied thereto. The thermal expansion coefficient of the base board is greater than that of Material (I). However, there can be easily obtained a base board having a thermal expansion coefficient of 10 x 10⁻⁶K⁻¹ or less by selecting an apparent porosity. Further, the thermal conductivity of the base board is equivalent to, or higher than, that of Material (I). As a result, the base board can be suitably used as a base board on which IC chips and package modules can be directly mounted.

Printed wiring can be produced on the above base board for printed wiring. Thus, in the process of the invention, typically through holes are made in the resulting base board, the base board is plated with metal and the intended printed wiring network is formed on the plated base board. Alternatively, the base board is can be plated with metal, through holes can be made in the plated base board, the through holes can be plated and the intended printed wiring network can be formed on the based board. In particular, the former method works the physical properties of the base board for printed wiring, provided by the present invention, and permits the formation of a very fine printed wiring network since the through holes and the base board surface can be plated with copper in the same copper plating thickness and processed for forming the printed wiring.

When the above metal plating is carried out, the base board can be surface-treated, and then plated by a known wet electroless plating method, a sputtering method, other dry method, or a copper plating method using copper formate. This surface treatment can be carried out by a method of treatment with a silane coupling agent, particularly an aminosilane coupling agent, a method of etching part of the inorganic material with an acid aqueous solution of phosphoric acid, sulfuric acid or chromic acid, a method of further treating the so-treated base board with a coupling agent, a method of etching part of the resin with an alkaline aqueous solution of sodium hydroxide or other or a method of treating the so-treated base board with a coupling agent. When a dry plating method is used, it is preferred to use a treatment solution containing an organic solvent such as an alcohol, a ketone or the like in place of water.

### Examples

The present invention will be explained further in detail hereinafter by reference to Examples.

### Example 1

A thermosetting resin composition (to be referred to as "resin II-1" hereinafter) was preapred from 87 % by weight of a cyanate-maleimide resin [trade name: BT-2100, 2,2-bis(4-cyanatophenyl)propane/bis(4-maleimidephenyl)methane = 9/1 (weight ratio)], 10 % by weight of a bisphenol A type epoxy resin (trade name: Epikote 152, epoxy equivalent 172 - 179, supplied by YukaShell Epoxy K.K.) and 3 % by weight of a γ-glycidoxypropyltrimethoxysilane.

Separately, grooves having a depth of about 0.5 mm were formed, with a cutter, on both surfaces of each of five blocks of a β-wollastonite porous material ("MACHINAX" supplied by INAX Corp., bulk density 2.1, apparent porosity 21 %, average pore radius 3.4 µm) having a size of 15.4 cm x 15.4 cm x 4 cm at intervals of 10 mm.

The above five blocks were placed in an aluminum container having, as partition, copper wires having a diameter of 1 mm, and the aluminum container with the five blocks therein was placed in a dryer and dried at 150°C for 4 hours.

The dried five blocks were then placed in a vacuum impregnator, and the pressure in the vacuum impregnator was reduced to 5 mmHg. Then, the temperature inside the vacuum impregnator was increased to 110°C, the five blocks were maintained at this temperature for 1 hour to carry out the drying treatment under vacuum.

The above-prepared resin II-1 was fed to a resin container in the vacuum impregnator, degassed by melting it at 110°C and gradually poured into the aluminum container to carry out the impregnation of the five blocks for 1 hour.

The aluminum container was taken out, the resin on the surfaces of each block was lightly cleaned off with a spatula and then each block was placed on two rods having a triangular cross section. The five blocks were placed in dryers, and cured at 150°C for 1 hour, at 180°C for 30 minutes, at 185°C for 15 minutes, at 200°C for 1 hour and at 230°C for 3 hours to give composite materials. While the blocks were cured at 180°C, the resin on the block surfaces was wiped off with a piece of cloth.

The above-obtained composite materials were temporarily attached with an adhesive, set on a multiblade saw (blade thickness 0.25 mm, length 500 mm, using a #600 SiC abrasive spindle oil solution) and cut to boards having a size of 15 cm x 15 cm x 0.635 mm and boards having a size of 15 cm x 15 cm x 1.6 mm. In this case, the number of the boards having a thickness of 0.635 mm was the same as the number of boards having a thickness of 1.6 mm.

The base boards having a thickness of 1.6 mm were measured for physical properties. Table 1 shows the results.

### Example 2

A thermosetting resin composition (to be referred to as "resin II-2" hereinafter) was preapred from 98 % by weight of a cyanate-maleimide resin [trade name: BT-2100, 2,2-bis(4-cyanatophenyl)propane/bis(4-maleimidephenyl)methane = 9/1 (weight ratio)] and 2 % by weight of a bisphenol A type epoxy resin (trade name: Epikote 152, epoxy equivalent 172 - 179, supplied by Yuka-Shell Epoxy K.K.).

Then, Example 1 was repeated except that the resin II-1 was replaced with the above resin II-2, that blocks of β-wollastonite were replaced with four blocks of an aluminum nitride-boron nitride composite material (h-BN content 20 %, bulk density 1.7, apparent porosity 31 %, average pore diameter 1.2 µm) and that the above blocks were preliminarily dried at 70°C for 72 hours.

The base boards having a thickness of 1.6 mm were measured for physical properties. Table 1 shows the results. The base boards having a thickness of 0.635 were machinable by punching.

**Table 1**

| | Unit | Ex. 1 | Ex. 2 |
|---|---|---|---|
| Bulk density*1 | g/cm³ | 2.51 | 2.73 |
| Water absorption*2 | % | 0.2 | 0.1 |
| Flexural strength | MPa | 140 | 170 |
| Dielectric constant*3 | | 4.0 | 6.3 |
| Dielectric loss tangent*3 | | 0.006 | 0.002 |
| Coefficient of | | 8.0 | 5.1 |
| thermal expansion*5 | 10⁻⁶K⁻¹ | | |
| Thermal | | 3.1 | 70 |
| conductivity*5 | W(mK)⁻¹ | | |
| Chemical Resistance*6 | | | |
| 10 % HCl | | 1.1 | +0.3 |
| 10 % NaOH | | +0.5 | +0.5 |

| | | | |
|---|---|---|---|
| Notes: Ex. = Example *1: JIS-C-2141, unit g/cm³ | | | |
| *2: JIS-R-1601, unit % | | | |
| *3: JIS-C-2141, measured at 1 MHz | | | |
| *4: Measurement range, room temperature --> 300°C, unit x10⁻⁶K⁻¹ *5: Measured by a laser flash method, unit W(mk)⁻¹ | | | |
| *6: Sample 50 mm x 50 mm x 1.6 mm, immersed at 23°C, 24 hours, and measured elution amount, unit mg/cm². "+" shows an increase. | | | |

As explained above, the base board for printed wiring, obtained according the process of the present invention, is with remarkably high thickness accuracy and mass-producible since a plurality of base boards are produced at the same time by easily slicing the composite material with a slicing apparatus. Further, the base board of the present invention has a low coefficient of thermal expansion and high heat dissipation properties and has higher heat resistance than a cured product of the resin used for the impregnation. The base board produced by the process of the present invention is therefore useful as a base board for an antenna for high frequency, a part module for high frequency and others and as a base board for directly mounting semiconductor chips.

## Claims

1. A process for the production of a base board for printed wiring, which comprises impregnating a block of an inorganic continuous porous material (I) with a thermosetting resin (II) in an impregnation vessel under reduced pressure, taking the impregnated block out of the impregnation vessel, substantially removing the thermosetting resin (II) adhering to surfaces of the impregnated block before the thermosetting resin (II) forms a gel, curing the remaining thermosetting resin under heat to form a composite material (III), and slicing the composite material (III) into base boards having a thickness of 0.2 to 2 mm and a thickness allowance of ± 5 µm or less.

2. A process according to claim 1, wherein the material (I) has the form of a plate whose surface is rectangular or square.

3. A process according to claim 2, wherein the material (I) has a thickness of from 3 to 10 cm, a length of from 5 to 30 cm and a width of from 5 to 40 cm.

4. A process according to any one of the preceding claims, wherein material (I) has an average pore diameter of from 0.1 to 10 µm and a porosity of from 10 to 40%

5. A process according to any one of the preceding claims, wherein material (I) has an apparent porosity of from 12 to 36% and an average pore diameter of from 0.5 to 6 µm and is formed of aluminium nitride-hexagonal boron nitride (AlN-h-BN) or β-wollastonite (β-CaSiO₃).

6. A process according to any one of the preceding claims, wherein material (I) is preliminarily heat-treated under reduced pressure at a temperature of from 70 to 250°C for from 0.5 to 72 hours.

7. A process according to any one of the preceding claims, wherein the thermosetting resin (II) is a phenolic resin, an epoxy resin, an unsaturated polyester resin, a diallyl phthalate resin, an acrylic resin, a cyanato resin, a maleimide resin, a maleimide-vinyl resin or a mixture of two or more thereof.

8. A process according to any one of the preceding claims, wherein the composite material (III) is sliced with a multiwire saw, a multiwire saw with diamond on wire, a multiblade saw, a multiblade saw with diamond on blade or an inner diameter slicing diamond saw.

9. A process according to any one of the preceding claims, wherein through holes are made in the resulting base board, the base board is then plated with metal and the intended printed wiring network is formed on the plated base board.

10. A process according to any one of claims 1 to 8, wherein the resulting base board is plated with metal, through holes are made in the plated base board, the through holes are plated and the intended printed wiring network is formed on the base board.

## Patentansprüche

1. Verfahren zur Herstellung einer Basisplatte für gedruckte Schaltungen, umfassend das Imprägnieren eines Blocks aus einem anorganischen, kontinuierlichen, porösen Material (I) mit einem wärmehärtbaren Harz (II) in einem Imprägniergefäß unter reduziertem Druck, das Entnehmen des imprägnierten Blocks aus dem Imprägniergefäß, das weitgehende Entfernen des wärmehärtbaren Harzes (II), das an den Oberflächen des imprägnierten Blocks haftet, bevor das wärmehärtbare Harz (II) ein Gel formt, das Härten des verbleibenden wärmehärtbaren Harzes unter Wärmezufuhr, um ein Verbundmaterial (III) zu formen, und das Zerschneiden des Verbundmaterials (III) zu Basisplatten mit einer Dicke von 0,2 bis 2 mm und einer Dicketoleranz von ± 5µm oder weniger.

2. Verfahren nach Anspruch 1,
wobei das Material (I) die Gestalt einer Platte hat, deren Oberfläche rechteckig oder quadratisch ist.

3. Verfahren nach Anspruch 2,
wobei das Material (I) eine Dicke von 3 bis 10 cm, eine Länge von 5 bis 30 cm und eine Breite von 5 bis 40 cm aufweist.

4. Verfahren nach einem der vorhergehenden Ansprüche, wobei das Material (I) einen durchschnittlichen Porendurchmesser von 0,1 bis 10 µm und eine Porosität von 10 bis 40 % hat.

5. Verfahren nach einem der vorhergehenden Ansprüche, wobei das Material (I), eine apparente Porosität von 12 bis 36 % und einen durchschnittlichen Porendurchmesser von 0,5 bis 6 µm hat und aus einem Aluminiumnitrid-hexagonalen-bornitrid (AlN-h-BN) oder β-Wollastonit (β-CaSiO₃) geformt ist.

6. Verfahren nach einem der vorhergehenden Ansprüche, wobei das Material (I) zuvor unter reduziertem Druck bei einer Temperatur von 70 bis 250°C 0,5 bis 72 Stunden lang wärmebehandelt wird.

7. Verfahren nach einem der vorhergehenden Ansprüche, wobei das wärmehärtbare Harz (II) ein Phenolharz, ein Epoxyharz, ein ungesättigtes Polyesterharz, ein Diallylphthalatharz, ein Acrylharz, ein Cyanatharz, ein Maleimidharz, ein Maleimidvinylharz oder ein Gemisch aus zwei oder mehr derselben ist.

8. Verfahren nach einem der vorhergehenden Ansprüche, wobei das Verbundmaterial (III) mit einer Mehrfachdrahtsäge, einer Mehrfachdrahtsäge mit diamantbesetzten Drähten, einer Mehrfachblattsäge, einer Mehrfachblattsäge mit diamantbesetzten Blättern oder einer Innendurchmesserdiamantsäge geschnitten wird.

9. Verfahren nach einem der vorhergehenden Ansprüche, wobei Durchgangslöcher in die resultierende Basisplatte gemacht werden, die Basisplatte dann mit Metall plattiert und das gewünschte gedruckte Schaltungsnetzwerk auf der plattierten Basisplatte geformt wird.

10. Verfahren nach einem der Ansprüche 1 bis 8,
wobei die resultierende Basisplatte mit Metall plattiert, Durchgangslöcher in die plattierte Basisplatte gemacht, die Durchgangslöcher plattiert und das gewünschte gedruckte Schaltungsnetzwerk auf der Basisplatte geformt wird.

## Revendications

1. Procédé de fabrication d'une carte-support pour circuit imprimé, qui comprend les étapes consistant à imprégner un bloc en matière minérale poreuse continue(I) d'une résine thermodurcissable (II) dans un récipient d'imprégnation, sous pression réduite, retirer le bloc imprégné du récipient d'imprégnation, ôter pratiquement la résine thermodurcissable (Il) adhérant aux surfaces du bloc imprégné avant que la résine thermodurcissable (Il) forme un gel, faire durcir à chaud la résine thermodurcissable restante pour former un matériau composite (III), et découper le matériau composite (III) en tranches pour former des cartes-supports ayant une épaisseur de 0,2 à 2 mm, la tolérance quant à l'épaisseur étant de ± 5 µm ou moins.

2. Procédé selon la revendication 1, dans lequel la matière (I) est sous la forme d'une plaque rectangulaire ou carrée.

3. Procédé selon la revendication 2, dans lequel la matière (I) a une épaisseur de 3 à 10 cm, une longueur de 5 à 30 cm et une largeur de 5 à 40 cm.

4. Procédé selon l'une quelconque des revendications précédentes, dans lequel la matière (I) est une matière ayant un diamètre de pore moyen de 0,1 à 10 µm et une porosité de 10 à 40 %.

5. Procédé selon l'une quelconque des revendications précédentes, dans lequel la matière (I) est une matière ayant une porosité apparente de 12 à 36 % et un diamètre de pore moyen de 0,5 à 6 µm, qui est constituée d'un mélange de nitrure d'aluminium et de nitrure de bore hexagonal (AlN-h-BN) ou de β-wollastonite (β-CaSiO₃).

6. Procédé selon l'une quelconque des revendications précédentes, dans lequel on soumet au préalable la matière (I) à un traitement thermique sous pression réduite, à une température comprise dans l'intervalle allant de 70 °C à 250 °C, pendant une durée de 0,5 à 72 heures.

7. Procédé selon l'une quelconque des revendications précédentes, dans lequel la résine thermodurcissable (II) est une résine phénolique, une résine époxy, une résine de polyester insaturé, une résine à base de phtalate de diallyle, une résine acrylique, une résine cyanato, une résine de type maléimide, une résine de type maléimide-vinylique ou un mélange de deux ou plus de deux des résines précédentes.

8. Procédé selon l'une quelconque des revendications précédentes, dans lequel le matériau composite (III) est découpé en tranches au moyen d'une scie multifil, d'une scie multifil à diamant sur le fil, d'une scie multilame, d'une scie multilame à diamant sur la lame ou d'une scie à diamant découpant au diamètre interne.

9. Procédé selon l'une quelconque des revendications précédentes, dans lequel on perce des trous traversants dans la carte-support résultante, on métallise ensuite la carte-support et on forme sur la carte-support métallisée le réseau du circuit imprimé voulu.

10. Procédé selon l'une quelconque des revendications 1 à 8, dans lequel on métallise la carte-support résultante, on perce des trous traversants dans la carte-support métallisée, on métallise les trous traversants et on forme sur la carte-support le réseau du circuit imprimé voulu.
